# EUROPEAN PATENT APPLICATION

(11) **EP 4 807 993 A1**
(43) Date of publication of application: **16.09.2026**
(21) Application number: 25162474.8
(22) Date of filing: 09.03.2025
(51) Int. Cl.: H03K 17/96, G04C 23/14, G04G 15/00

(54) **A PROGRAMMABLE TOUCH-CONTROLLED TIMER SWITCH BASED ON CAPACITIVE SENSING**

(71) Applicant: IMP Pumps d.o.o., 1218 Komenda (SI)
(72) Inventor: Svetlin, Janez, 1218 Komenda (SI)
(74) Representative: Patentni Biro AF d.o.o.

(57) **Abstract**

The present invention belongs to the field of timers and switches for controlling operation of various devices, such as heating, pumps, lights, etc. The programmable touch-operated timer switch based on capacitive sensing according to the invention comprises at least a plastic housing and a base body with a power supply socket, a connection port allowing connection to the device to be controlled, preferably a pump, and a PCB mounted on the upper surface of the base body, wherein the PCB is provided with:
- 6 to 48 capacitive sensing elements, preferably in linear or circular arrangement, arranged to detect a touch by the user according to which the duration of a set period is determined,
- a plurality of LED lights in the same arrangement as sensors indicating hours of the day,
- optionally additional LEDs to indicate mode of operation, if several modes of operation are enabled,
- at least one mode switch button,
- a microcontroller arranged to measure the capacitance with the capacitive sensing elements, display of time, selection of operation modes, and support elements, such as power supply and similar components, which are known to the skilled person, wherein the software installed on the microprocessor is arranged to measure the capacitance on every capacitive sensor and calculates finger touch position for 24 or more virtual locations, and
- power relay or other driving elements.

## Description

### Field of the invention

The present invention belongs to the field of timers and switches for controlling operation of various devices, such as heating, pumps, lights, etc. The invention relates to a programmable touch-controlled timer switch based on capacitive sensing.

### Background of the invention and the technical problem

A timer switch is a device that operates an electric switch controlled by a timer. First models were introduced in 1945 for controlling lights, electric signs and heating devices. The timer switch may be built into power circuits, for example with a central heating or water heater timer, plugged into a wall outlet with equipment plugged into the timer instead of directly into the power point; or built into equipment. Usual timer switches have a housing with a front plate set up as user interface, where the time for operation is defined with rotation of a knob, pressing a button or combination of buttons or combination of both.

Known timer switches are problematic for use in heating systems due to their size and high number of moving parts, the mechanical clock with a synchronous motor that drives a high number of gears, gears can jam and clocks often fall behind time, complex assemblies, and loud operation due to mechanical contacts. Furthermore, when it loses power, clock stands still.

Therefore, the technical problem solved by the present invention is design of a timer switch that will address the disadvantages of the known solutions.

### Prior art

Programmable timer switches existing in the market only use rotation of a knob, pressing a button or combination of buttons or combination of both, as already mentioned above.

### Description of the solution to the technical problem

The present invention aims to address the disadvantages of known solutions and aims to provide a reliable time switch arranged to be installed in various devices or as standalone controllers to ensure regulation of their operation during the day. According to the applicant's knowledge, none of the existing programmable timer switches use capacitive sensing. The technical problem is solved as defined in the independent claim, wherein the preferred embodiments are defined in dependent claims.

The essence of the invention is that the programmable timer switch is designed with no moving parts, which is an important upgrade of known mechanical timer switches that comprise more than 100 movable parts. Elimination of movable parts is achieved by using a plurality of capacitive sensors arranged to detect touch of user to set the operation of the device to be controlled with the programmable timer switch, usually hours of operation.

The programmable touch-operated timer switch based on capacitive sensing according to the invention comprises at least the following:
- a housing corresponding to the shape of the base body, wherein the housing is made from a plastic material and comprises:
   ∘ a part corresponding to the power supply socket of the base body,
   ∘ sides to cover the sides of the base body and
   ∘ a top surface arranged to cover a printed circuit board (PCB) from above and wherein the top surface is immediately above the PCB, said top surface is also provided with at least two buttons and suitable holes, clear inserts or transparent stickers arranged to allow light from LEDs to pass through and indicate set timers to the user and/or the mode of operation,
   o connection to the device to be controlled by the programmable timer switch, wherein the PCB is installed as closely as possible to the housing, and wherein the plate of the housing covering the PCB is designed as thin as possible, which improves sensing,
- a base body with a power supply socket, a connection port allowing connection to the device to be controlled, preferably a pump, and a PCB mounted on the upper surface of the base body, wherein the PCB is provided with:
   ∘ 6 to 48, preferably 12 to 24, capacitive sensing elements, preferably in linear or circular arrangement, arranged to detect a touch by the user according to which the duration of a set period is determined, wherein resolution is not determined with number of sensors, as interpolation can provide values between to determine which end point has been set by the user,
   ∘ a plurality, preferably from 24 to 96, LED lights in the same arrangement as sensors indicating hours of the day, wherein in preferred embodiments 96 LED lights are used for intervals of 15min, 48 for 30 min intervals, while 24 are needed for 1 h intervals,
   ∘ optionally additional LEDs to indicate mode of operation, if several modes of operation are enabled,
   ∘ at least one mode switch button (capacitive or other input devices possible),
   ∘ a microcontroller arranged to measure the capacitance with the capacitive sensing elements, display of time, selection of operation modes, and support elements, such as power supply and similar components, which are known to the skilled person, wherein the software installed on the microprocessor is arranged to measure the capacitance on every capacitive sensor and calculates finger (touch) position for 24 or more virtual locations,
   ∘ power relay or other driving elements to turn on or off the device controlled by the timer switch,
- optionally a sticker to mark which button or light has which meaning, and
- optionally a power plug or similar element to allow powering of the programmable timer switch.

The PCB on the top surface of the base body has an essentially circular shape with an elongation for the power supply port. Further, the PCB has on its circumference a plurality of sensing pads, each with one capacitive sensor, preferably 12 to 24 sensing pads, arranged to sense a touch of a user through the top plate of the housing, a plurality of indicator lights, preferably from 12 to 96, arranged in a circular manner next to the sensing pads that are arranged to light when the sensing pad assigned to them senses a touch from the user, two buttons for selection of operation modes provided in the approximate centre of the PCB, a microcontroller installed on the PCB as well as connection pins for connection to the device.

The microcontroller measures capacitance of each sensor using any of the known method, such as charge transfer, charge time, frequency shift or other, which are known to the skilled person.

By pressing finger to a clock dial drawn on the circumference of the product, user can toggle LED at selected location on and off, imitating mechanically adjusted 24-hour timer. Because LEDs have multiple meanings, there can be multiple markings next to each one. Which label is valid at the time is indicated by the additional Mode LEDs.

Since the plastic housing has a thickness, the PCB is separated from fingers by this thickness, wherein the proximity of a finger only changes capacitance of sensors in the range of 0.01% - 0.1%. Due to this constraint, an algorithm according to a preferred embodiment can be used. In this algorithm, each sensor's capacitance is measured rapidly (for example over 10.000 times per second). For each sensor, a short-term average is calculated and compared to long-term average to separate touch from noise. Long-term average changes asymmetrically (i.e., different rate for increase/decrease) to avoid capturing other phenomena like grid frequency or disturbances from power supply. Calibration is performed automatically at start.

In designs where noise-to-signal is lower, for example if different material is used for the housing, such that thinner walls of the housing is enabled, a different, simplified algorithm can be used to save on software complexity, memory and computation cost.

The programmable touch-operated timer switch based on capacitive sensing according to the invention has several different modes of operation:
- Normal / stand-by: timer is running with the clock and the driven device is turned on or off depending on current time and setting. Clock LEDs might be turned off or current hour might be on or blinking or other visual display might be implemented to show time and device status. No other inputs are active.
- Clock setting - hour: set the current hour
- Clock setting - minute: (optionally) set the current minute
- Interval settings: mark intervals when the device is switched on or off. This can be done by a single touch or by a swipe from-to desired time,
wherein each mode can have its own dedicated LED to mark it is currently active, and wherein the modes are switched by pressing the button in a circular manner, Additional modes: the same arrangement can also be used, for instance, as a thermostat.

In comparison to known mechanical programmable timer switches having a rotating dial that turns with the clock and 24 or more toggle switches, the present invention uses LED lights instead of toggle switches. The same lights are also used to indicate current time. Toggling an LED is done by touching the housing near the desired interval/hour. This eliminates mechanical gears and levers of classical mechanical 24h timer. Because sensing is done over solid plastic, no movable seals are needed. There is no need to use fingernails as with mechanical timer as software filters the dominant press location (centre of the finger) and rejects presses in proximity. Issues with thick fingers are reduced and product can be further miniaturized.

Additional product features can be adjusted on the same interface of the time switch, such as temperature ranges, days of week or device's operating modes. Adjustment can also be cancelled midway and restored to previous configuration. All these steps are controlled and performed through the microcontroller.

There are two mechanical pushbuttons on the front panel, connected to microcontroller. These are used to select various operating modes and also to unlock touch interface during configuration. The timer switch thus preferably allows locking and unlocking of the touch pads during use to prevent any unwanted or accidental entries.

The timer switch can be adapted to run with no power (battery, capacitor, etc.), in cases of use in low voltage applications. This is not possible with mechanical versions due to high power consumption. However, the timer switch is usually provided with a power source such as a battery, capacitor, solar cells or similar.

The programmable timer switch can be made in any size, depending on the intended use, has lower complexity and lower power consumption as currently known programmable timer switches. The design with capacitive sensors allows more accurate settings with less faults, while at the same time use of the same interface for other functions and settings of the device is possible. The housing of the programmable timer switch is air and watertight, if suitable seals are installed.

The present invention can be used to control operation of various devices, such as heating, pumps, lights, etc.

The invention will be described in further detail based on an exemplary embodiment and figures, which show:
- Figure 1: an explosion view of the device to be controlled with the timer according to a possible embodiment comprising a base body with the PCB plate, a housing and a sticker
- Figure 2: the PCB plate

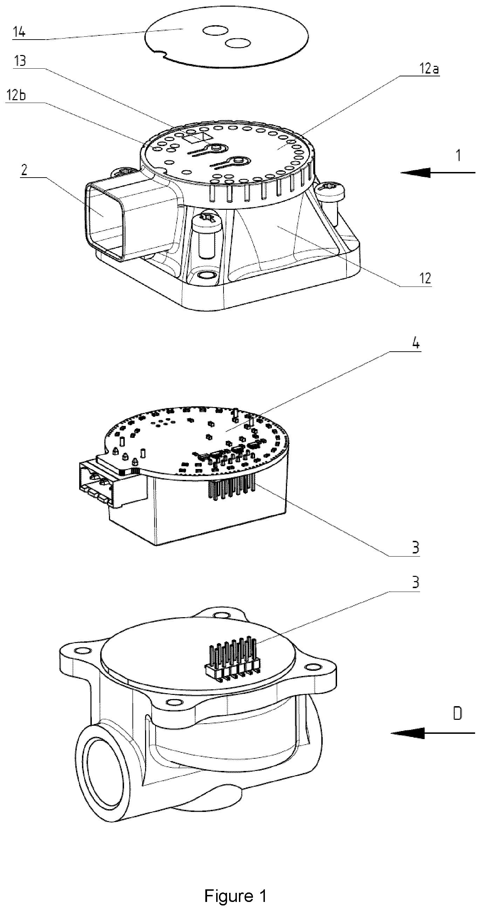

The programmable touch-controlled timer switch based on capacitive sensing according to a possible embodiment shown in figure 1 comprises the following components:
- a base body 1 with a power supply socket 2, a connection port 3 allowing connection to the device to be controlled, preferably a pump, and a PCB 4 mounted on the upper surface 1a of the base body 1, wherein the PCB 4 is provided with:
   ∘ 6 to 48, preferably 12 to 24, capacitive sensing elements 5, preferably in linear or circular arrangement, arranged to detect a touch by the user according to which the duration of a set period is determined,
   o a plurality, preferably from 24 to 96, LED lights 6 in the same arrangement as sensors indicating hours of the day, wherein in preferred embodiments 96 LED lights are used for intervals of 15min, 48 for 30 min intervals, while 24 are needed for 1 h intervals,
   ∘ optionally additional LEDs 7, 8 to indicate mode of operation, if several modes of operation are enabled,
   ∘ one or more mode switch button 9,
   ∘ the microcontroller 10 arranged to measure the capacitance with the capacitive sensors 5, display of time, and programand support elements, such as power supply and similar components, which are known to the skilled person,
   o power relay or other driving elements 11,
- a housing 12 corresponding to the shape of the base body 1, wherein the housing 12 is made from a plastic material and comprises a part corresponding to the power supply socket 2 of the base body 1, sides to cover the sides of the base body 1 and a top surface 12a arranged to cover the PCB 4 from above and wherein the top surface 12a is immediately above the PCB 4, said top surface 12a is also provided with two buttons 13 and suitable openings 12b to allow the lights to shine through and indicate set timers to the user and/or the mode of operation,
- a sticker 14 to mark which button 7, 8, 9 or light 6 has which meaning.

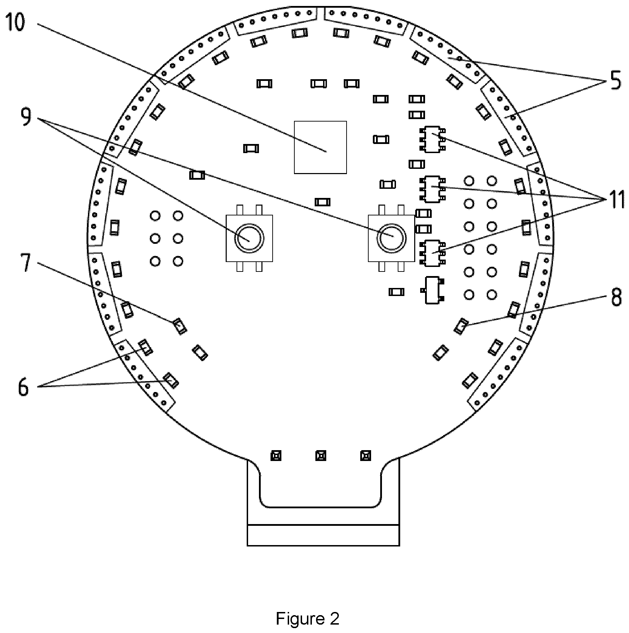

Figure 2 shows the PCB 4, wherein the PCB 4 on the top surface 1a of the base body 1 has an essentially circular shape with an elongation for the power supply port 2. Further, the PCB 4 has on its circumference twelve sensing pads with capacitive sensors 5 arranged to sense a touch of a user through the top surface 12a of the housing 12, twenty-four indicator lights 6 arranged in a circular manner next to the sensing pads that are arranged to light when the sensing pad assigned to them senses a touch from the user, two buttons 7, 8 for setting operation modes provided in the approximate centre of the PCB 4, the microcontroller 10 installed on the PCB 4 as well as connection pins for connection to the device to be controlled.

## Claims

1. **A programmable** touch-controlled timer switch based on capacitive sensing, wherein said timer switch comprises
- a plurality of capacitive sensors arranged to detect touch of user to set the operation of the device to be controlled with the programmable timer switch, and a
- a microcontroller arranged to measure the capacitance on every capacitive sensor and calculates touch position for a plurality of virtual locations.

2. The programmable touch-controlled timer switch based on capacitive sensing according to claim 1, wherein the timer switch comprises at least the following:
- a housing corresponding to the shape of the base body, wherein the housing is made from a plastic material and comprises:
∘ a part corresponding to the power supply socket of the base body,
∘ sides to cover the sides of the base body and
∘ a top surface arranged to cover a printed circuit board (PCB) from above and wherein the top surface is immediately above the PCB, said top surface is also provided with at least two buttons and suitable holes, clear inserts or transparent stickers arranged to allow light from LEDs to pass through and indicate set timers to the user and/or the mode of operation,
∘ connection to the device to be controlled by the programmable timer switch,
wherein the PCB is installed as closely as possible to the housing, and wherein the plate of the housing covering the PCB is designed as thin as possible, which improves sensing,
- a base body with a power supply socket, a connection port allowing connection to the device to be controlled, and a PCB mounted on the upper surface of the base body, wherein the PCB is provided with:
o 6 to 48 capacitive sensors arranged to detect a touch by the user according to which the duration of a set period is determined,
∘ a plurality, preferably from 24 to 96, LED lights in the same arrangement as sensors indicating hours of the day,
∘ at least one mode switch button,
- the microcontroller arranged to measure the capacitance with the capacitive sensing elements, display of time, selection of operation modes,
- power relay or other driving elements to turn on or off the device controlled by the timer switch.

3. The programmable touch-controlled timer switch based on capacitive sensing according to claim 1 or claim 2, wherein from 12 to 24 capacitive sensors are provided.

4. The programmable touch-controlled timer switch based on capacitive sensing according to any of the preceding claims, wherein the capacitive sensors are provided in a linear or a circular arrangement.

5. The programmable touch-controlled timer switch based on capacitive sensing according to any of the preceding claims, wherein from 24 to 96 LED lights are provided.

6. The programmable touch-controlled timer switch based on capacitive sensing according to the preceding claim, wherein 96 LED lights are used for intervals of 15min, 48 LED lights are used for 30 min intervals, or 24 LED lights are needed for 1 h intervals.

7. The programmable touch-controlled timer switch based on capacitive sensing according to any of the preceding claims, wherein additional LEDs are provided to indicate mode of operation, if several modes of operation are enabled.

8. The programmable touch-controlled timer switch based on capacitive sensing according to any of the preceding claims, wherein the timer switch further comprises a power plug or similar element to allow powering of the programmable timer switch.

9. The programmable touch-controlled timer switch based on capacitive sensing according to any of the preceding claims, wherein the timer switch further comprises a sticker to mark which button or light has which meaning.

10. The programmable touch-controlled timer switch based on capacitive sensing according to any of the preceding claims, wherein the microcontroller measures capacitance of each sensor using any of the known method, such as charge transfer, charge time, frequency shift or other, which are known to the skilled person.

11. The programmable touch-controlled timer switch based on capacitive sensing according to any of the preceding claims, wherein the timer switch is arranged to allow toggling **LED** at selected location on and off by pressing finger to the clock dial drawn on the circumference of the product.

12. The programmable touch-controlled timer switch based on capacitive sensing according to any of the preceding claims, wherein an algorithm is provided on the microcontroller, wherein each sensor's capacitance is measured rapidly, for example over 10.000 times per second, and for each sensor, a short-term average is calculated and compared to long-term average to separate touch from noise.

13. The programmable touch-controlled timer switch based on capacitive sensing according to any of the preceding claims, wherein the timer switch has several different modes of operation:
- Normal / stand-by: timer is running with the clock and the driven device is turned on or off depending on current time and setting,
- Clock setting - hour: set the current hour,
- Clock setting - minute: (optionally) set the current minute,
- Interval settings: mark intervals when the device is switched on or off,
wherein each mode can have its own dedicated **LED** to mark it is currently active, and wherein the modes are switched by pressing the button in a circular manner,

14. The programmable touch-controlled timer switch based on capacitive sensing according to any of the preceding claims, wherein the timer switch is provided with a power source such as a battery, capacitor, solar cells or similar.

15. The programmable touch-controlled timer switch based on capacitive sensing according to any of the preceding claims, wherein the timer switch is configured to control operation of heating device, pumps, and/or lights.
